Europäisches Patentamt

European Patent Office

Office européen des brevets

(11) Publication number: **0 075 320**
**B1**

# EUROPEAN PATENT SPECIFICATION

(45) Date of publication of patent specification: **28.05.86**

(51) Int. Cl.⁴: **H 02 M 7/06, H 01 G 4/40**

(21) Application number: **82108711.1**

(22) Date of filing: **21.09.82**

(54) Rectifying apparatus for automotive A.C. generator.

(30) Priority: **21.09.81 JP 141282/81 u**
**22.09.81 JP 141214/81 u**

(43) Date of publication of application:
**30.03.83 Bulletin 83/13**

(45) Publication of the grant of the patent:
**28.05.86 Bulletin 86/22**

(84) Designated Contracting States:
**DE FR GB**

(56) References cited:
**CH-A-3 779 923**
**DE-A-2 433 805**
**DE-A-2 856 193**
**FR-A-2 446 541**

**COMPONENTS REPORT, vol. 9, no. 4, October 1974, München, H. VOGT et al. "New rectifier assemblies for automobile generators", pages 97 to 100**

**Lechner Kurzwellenempfänger, VEB Militarverlag, Berlin (1975), p. 64**
**Practical Wireless, October 1980 p 45**
**ARRL Handbook (1980), pages 5-20**

(73) Proprietor: **MITSUBISHI DENKI KABUSHIKI KAISHA**
**2-3, Marunouchi 2-chome Chiyoda-ku Tokyo 100 (JP)**

(72) Inventor: **Yoshida, Yasuhiro**
**715-2, Aza Koyama Taishi-cho**
**Tonan Ibo County Hyogo Prefecture (JP)**

(74) Representative: **Popp, Eugen, Dr. et al**
**MEISSNER, BOLTE & PARTNER Postfach 86 06 24**
**D-8000 München 86 (DE)**

Courier Press, Leamington Spa, England.

**Description**

The invention relates to a rectifying apparatus for an automotive AC-generator, comprising at least a rectifying device for converting an AC-output of the AC-generator into a direct current, the rectifying device having a plurality of rectifiers, each comprising a capacitor connected in parallel with a diode.

A rectifying apparatus for an AC-generator of this type is already known from CH—A—377 923. However, this publication is concerned with quite another problem, namely how to avoid the difficulties with bridge-circuits due to electrical and thermal stresses of the semiconductor components. The problem how to make up a rectifying apparatus which is especially suitable for an automotive AC-generator is not discussed in this publication.

Furthermore, a rectifying apparatus for an ac-generator of the indicated type is known from other publications, for example from Synthesizer Receiver, page 45, Practical Wireless, October 1980. The rectifying apparatus as disclosed in this citation may be suitable for quite a number of purposes and applications, however, the publication is mainly concerned with interference problems in a power supply provided with a rectifying apparatus. Again, the problem is not discussed how to make up a rectifying apparatus which is especially suitable for an automotive AC-generator.

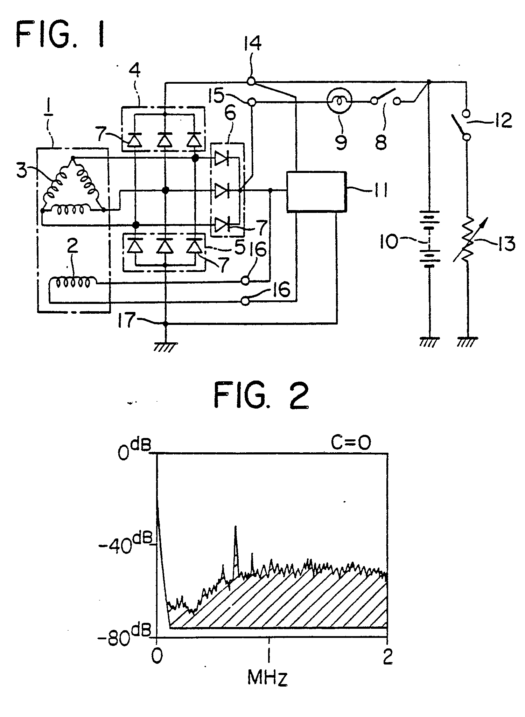

A conventional generator apparatus which accommodates an AC-generator and rectifying devices for a vehicle has a structure as shown in Fig. 1, having an AC-generator 1 and a field winding 2 which is mounted on a rotor of the AC-generator 1. The field winding 2 is energized from a stator section side through a slip ring unit (not shown). The rotor is driven by an automotive engine. An armature winding 3 is mounted on a stator of the AC-generator 1. The armature winding 3 involves 3-phase windings, which induce 3-phase AC-voltages. A first rectifying device 4 accommodates three sets of semiconductor rectifiers 7. The output voltage from the armature winding 3 is applied to the anode sides of the respective rectifying devices 4. A second rectifying device 5 accommodates three sets of semiconductor rectifiers 7. The output voltage from the armature winding 3 is applied to the cathode sides of the respective rectifying devices 5. Thus, both the first and the second rectifying devices 4 and 5 full-wave-rectify the AC-voltage output from the AC-generator 1. A third rectifying device 6 accommodates three sets of semiconductor rectifiers 7, which are connected in parallel with the rectifying device 4 with respect to a storage battery 10. The third rectifying device 6 is used as an excitation power source for the AC-generator 1. These respective rectifiers 7 are installed in a bracket (not shown) of the AC-generator 1. Reference numeral 8 denotes a key switch, and reference numeral 9 denotes a charge indication lamp which indicates the charging state of the AC-generator 1.

The storage battery 10 is charged by the DC-voltage output which is full-wave rectified by the rectifying devices 5 and 6. A voltage regulator 11 serves to maintain the output voltage of the AC-generator 1 at a predetermined level, and a load switch 12 opens or closes a circuit of an electric load 13 from the rectifying devices 4 and 5, and the storage battery 10. The circuit arrangement further comprises a DC-output terminal 14 of the rectifying device 4, an initial excitation terminal 15, field winding terminals 16, and a terminal 17 which is connected to an automotive body (ground).

The result of the DC-output from this conventional rectifying apparatus for a generator apparatus comprising a spectral analysis in the frequency range of 0 to 2 MHz is shown in Fig. 2, from which it is clear that noises of approx. −60 dB to −40 dB have been involved in the above DC-output in the frequency range of 0 to 2 MHz. Such noises which are contained in the above-described frequency band are detrimental for a radio transmitter/receiver.

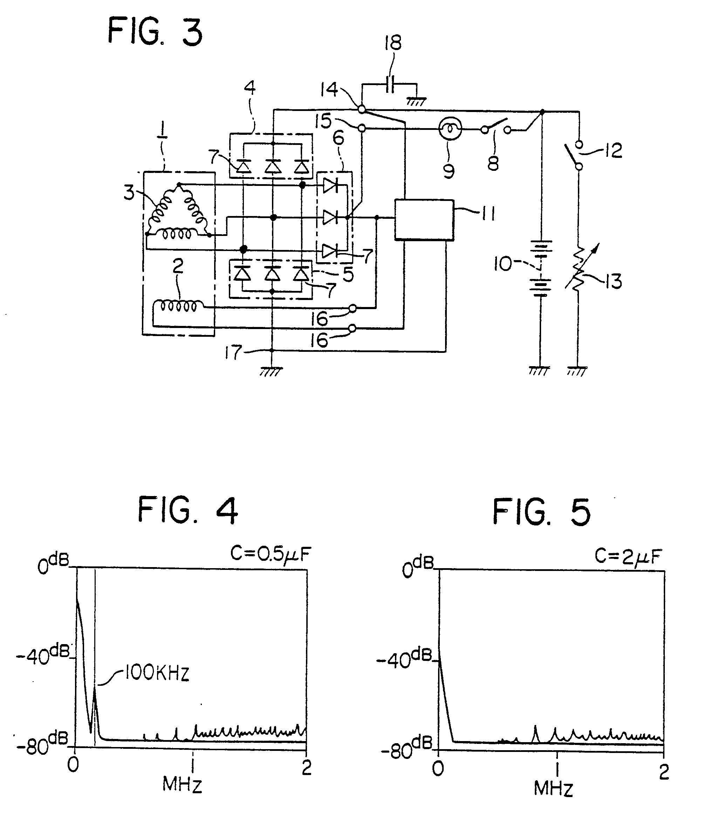

In order to remove such noise components from the DC-output of the conventional rectifying apparatus for an AC-generator, other embodiments have been tried, as shown in Fig. 3 This structure is substantially similar to the circuit of Fig. 1, but a capacitor 18 which accommodates a capacity of 0.5 to 2 μF is connected between the DC-output terminal 14 and the automotive body (ground) to absorb and reduce the noises which have been produced from the rectifying devices 4 and 5.

Figs. 4 and 5 show the results of the DC-output from this conventional rectifying apparatus for an AC-generator in Fig. 3 and comprise a spectral analysis in the frequency range of 0 to 2 MHz in terms of capacitors 18 accommodating capacities of 0.5 and 2 μF, respectively.

From Fig. 4, showing a case of the capacitor 18 having a capacitor of 0.5 μF, it is clear that most noises have been removed as compared with the result shown in Fig. 2 in the case of which no capacitor is connected. However, this result still shows noise in the range of 100 kHz which has not yet been removed sufficiently and remained.

From Fig. 5, showing a case of the capacitor 18 having a capacity of 2 μF, it is clear that the noise remaining in the vicinity of 100 kHz has almost completely been removed, and the noise level has also been reduced to approx. −70 dB, which causes almost no problem in practical use.

However, in the conventional rectifying apparatus described above, a capacitor having a relatively large capacity is required so as to completely remove the noises which have been produced from the rectifying devices 4 and 5. Thus, it is necessary to use a capacitor which has a large capacity of as low as 0.5 μF in the rectifying apparatus so as to remove the noises to a certain degree. Accordingly, this results in expensive costs and complicated works for the installation of the capacitor.

The object underlying the invention is to provide for a rectifying apparatus for an AC-generator, especially for an automotive AC-generator, which can be inexpensively constructed with a reduced amount of assembling work and reducing the overall size of the structure.

The solution according to the invention is characterized in that a parallel connector of rectifier and capacitor is formed as an integrated unit of a semiconductor chip diode and a capacitor arranged in parallel with each other between and soldered to an arm-shaped external connection terminal and a heat sink, respectively, and being insulated and sealed into a protecting sealing of synthetic resin.

One further development of such a rectifying apparatus according to the invention is characterized in that the rectifier is provided with a ring-shaped capacitor mounted on one end of the arm-shaped external connection terminal and surrounding the semiconductor chip diode, in that the heat sink has a bottom provided with a projection at the center thereof, wherein the semiconductor chip diode is connected at one end thereof to the projection of the heat sink, in that the capacitor is connected at one end thereof to the periphery of the bottom of the heat sink, and in that the semiconductor chip diode and the capacitor are connected at the other ends thereof to the arm-shaped external connection terminal, wherein the connections are made by solder material.

Another further development of the rectifying apparatus according to the invention is characterized in that the capacitor of the rectifier is formed in a box shape, in that the heat sink is formed as a planar component, in that the arm-shaped external connection terminal is formed with a bent end at the center thereof and bent outwards towards the heat sink, wherein the semiconductor chip diode is mounted towards the bent end of the arm-shaped external connection terminal, while the capacitor is provided at the not-bent end of the arm-shaped external connection terminal, and in that the semiconductor chip diode and the capacitor are connected at the other ends thereof to the heat sink, wherein the connections are made by solder material.

According to the present invention, the rectifying apparatus is composed of rectifiers each having a capacitor for rectifying the AC-output voltage from the AC-generator into a direct current. Therefore, the rectifying apparatus does not require the external connection of a capacitor having a large capacity of 2 μF as used in a conventional rectifying apparatus for an AC-generator. Therefore, it is possible to obtain a better noise reducing effect that in a conventional apparatus, to reduce the number of steps of assembling and working the apparatus, and to reduce the cots of apparatus.

The invention will be explained in detail in connection with preferred embodiments and with reference to the accompanying drawings, wherein

Fig. 1 is a circuit diagram of a conventional rectifying apparatus for an AC-generator;

Fig. 2 is a graphical representation of the spectral analysis of the DC-output of the conventional rectifying apparatus in Fig. 1;

Fig. 3 is a circuit diagram showing another rectifying apparatus for an AC-generator;

Figs. 4 and 5 are graphical representations of the spectral analysis of the DC-outputs of the rectifying apparatus which employ capacitors of 0.5 μF and 2 μF, respectively, in the apparatus in Fig. 3;

Fig. 6 is a circuit diagram showing an embodiment of a rectifying apparatus for an AC-generator according to the present invention;

Fig. 7 is a graphical representation of the spectral analysis of the DC-output of the rectifying apparatus in Fig. 6;

Fig. 8 is a front view showing a first embodiment of the rectifying device for the rectifying apparatus in Fig. 6;

Fig. 9 is a side view of the rectifying device in Fig. 8;

Fig. 10 is an enlarged sectional view of the rectifying device along the line A—A in Fig. 8;

Fig. 11 is an enlarged sectional view of the rectifying device along the line B—B in Fig. 9;

Fig. 12 is a front view showing a second embodiment of the rectifying device for the rectifying apparatus in Fig. 6;

Fig. 13 is a side view of the rectifying device in Fig. 12;

Fig. 14 is an enlarged sectional view of the rectifying device along the line C—C in Fig. 12; and

Fig. 15 is an enlarged sectional view of the rectifying device along the line D—D in Fig. 13.

Throughout the description, the same reference numerals denote the same or equivalent parts and components with respect to the accompanying drawings.

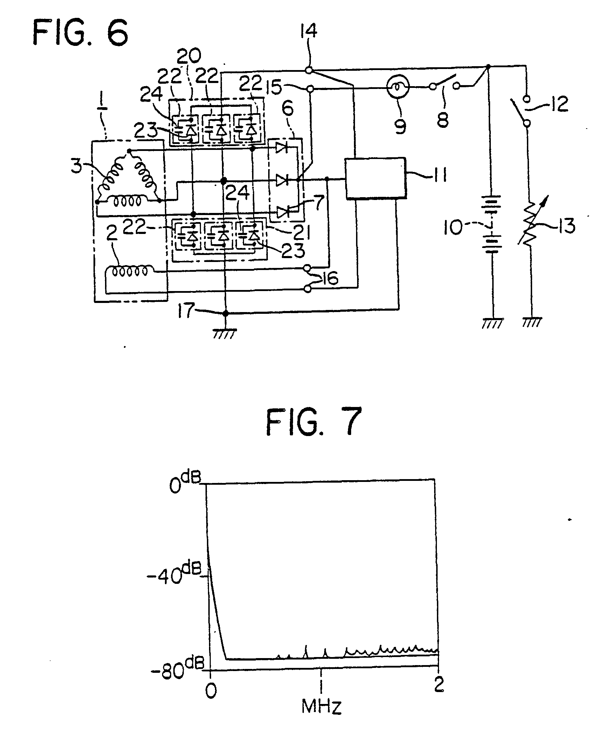

Fig. 6 is a circuit diagram showing a preferred embodiment of an automotive generator apparatus employing the rectifying apparatus according to the present invention, wherein reference numerals 1 to 3 and 6 to 17 denote the same units and components as employed in the conventional rectifying apparatus of Figs. 1 and 3. A first rectifying device 20 accommodates three sets of rectifiers 22. The output voltage from the armature winding 3 is applied to the anode sides of the rectifiers 22. A second rectifying device 21 accommodates three sets of rectifiers 22. The output voltage from the armature winding 3 is applied to the cathode sides of the rectifiers 22. Both the first and the second rectifying devices 20 and 21 full-wave-rectify the voltage from the armature winding 3 of the AC-genecator 1.

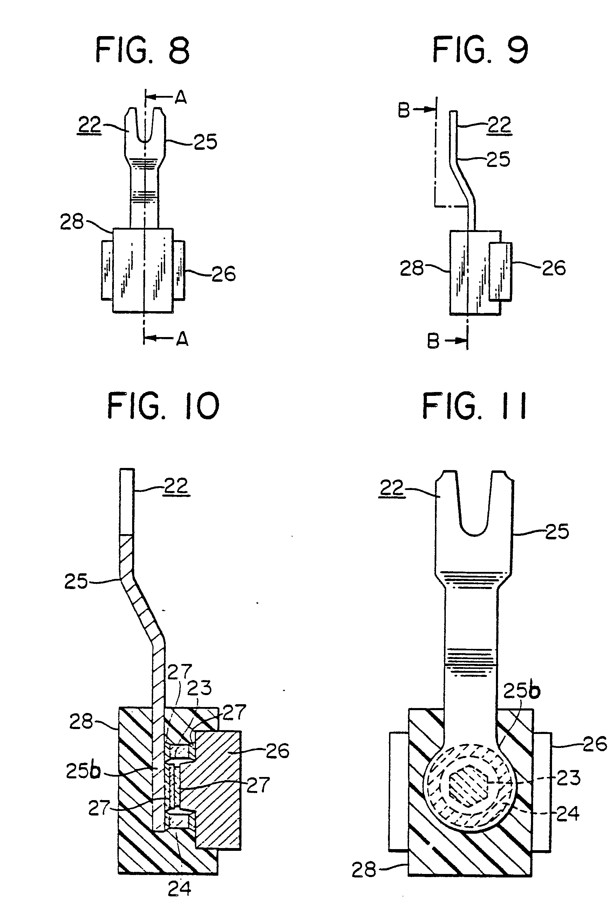

As will be described in detail with reference to Figs. 8 to 15, the rectifier 22 comprises a semiconductor chip diode 23 and a capacitor 24 connected in parallel with the semiconductor chip diode 23. The third rectifying device 6 has a low output, causing low noise level and hence is relatively low defective, and does accordingly not employ a capacitor, but comprises only the rectifiers 7.

Fig. 7 shows the result of the spectrally analyzed DC-output of the rectifying apparatus in Fig. 6. As shown in Fig. 7, noises are not substantially produced in the frequency range of 0 to 2 MHz, allowing the noise level to be reduced to the extent equivalent to or more than the rectifying apparatus which employs the capacitor 18 of 2 µF in Fig. 3.

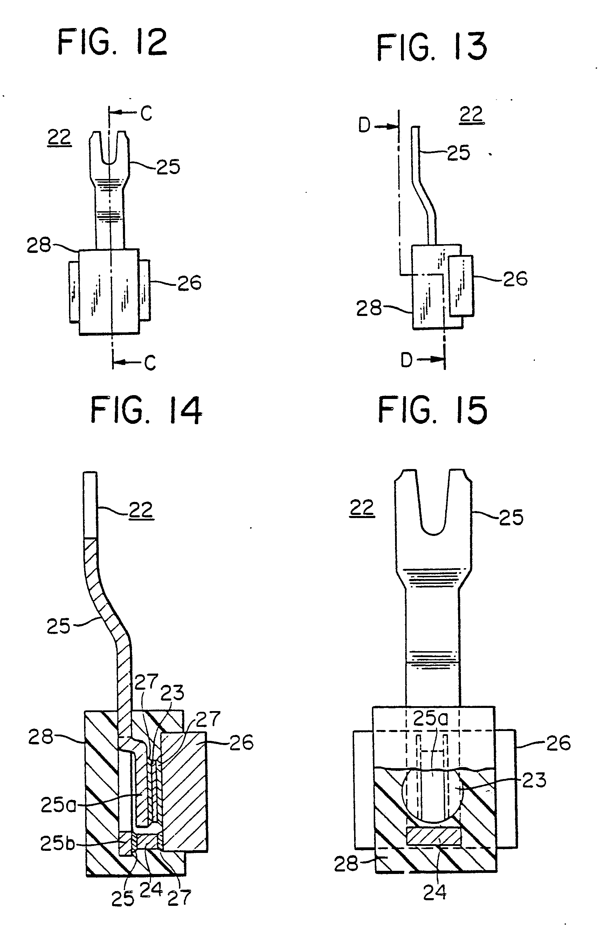

A preferred embodiment of the rectifier 22 thus employed in the rectifying apparatus of the present invention is shown in Figs. 8 to 11. Fig. 8 shows a front view, Fig. 9 shows a side view, Fig. 10 is an enlarged sectional view along the line A—A in Fig. 8, and Fig. 11 is an enlarged sectional view along the line B—B in Fig. 9. In this embodiment, the rectifier 22 is constructed as described below.

An arm-shaped external connection terminal 25 is made of metal. A semiconductor chip diode 23, functioning as a rectifier, is formed of a silicon chip and is soldered with a solder material 27 to the center of one end 25b of the arm-shaped external connection terminal 25. Further, a cylindrical capacitor 24 is soldered with a solder material 27 to the vicinity of the outer periphery of the end 25b of the arm-shaped external connection terminal 25. The semiconductor chip diode 23 and the capacitor 24 are respectively soldered with a solder material 27 to a heat sink 26, which is formed with a projection at the center of the bottom and is preferably made of metal.

In this manner, the semiconductor chip diode 23 and the capacitor 24 are connected in parallel with each other between the heat sink 26 and the arm-shaped external connection terminal 25. Reference numeral 28 denotes a protecting sealing to insulate and seal the parallel connector of the semiconductor chip diode 23 and the capacitor 24 between the end 25b of the terminal 25 and the heat sink 26. This protecting sealing 28 is formed, for example, of synthetic resin, and is molded with the synthetic resin. With the construction thus formed, the capacitor 24 is contained in the respective rectifiers 22. Thus, the static capacity of the capacitor 24 may be small enough to be approx. 1/10 of the conventional capacitor 18, and hence the outer dimension of the rectifier 22 is not increased.

Figs. 12 to 15 show another preferred embodiment of the rectifier 22, wherein the like units and components corresponding to those in the previous embodiment will be denoted by the same reference numerals as in Figs. 8 to 11. In this embodiment, a capacitor 24 is formed in a rectangular box shape as shown in Figs. 14 and 15. As shown in Fig. 14, the thickness of a semiconductor chip diode 23 is thinner than that of the capacitor 24. Accordingly, a notch is formed at the center of the not-bent end 25b of the arm-shaped external connection terminal 25, and is erected to form a bent end 25a. The semiconductor chip diode 23 is provided at the bent end 25a. The capacitor 24 is not provided at the not-bent end 25b, but is provided at the bent end 25a. A heat sink 26 which confronts the arm-shaped external connection terminal 25 is formed as a planar component. The semiconductor chip diode 23 and the capacitor 24 are respectively soldered to the heat sink 26 to form a parallel connector. This parallel connector is insulated and sealed by a protecting sealing 28 in the same manner as described with respect to the previous embodiment in Figs. 8 to 11.

## Claims

1. A rectifying apparatus for an automotive AC-generator, comprising at least a rectifying device (20, 21) for converting an AC output (3) of the AC-generator (1) into a direct current, the rectifying device (20, 21) having a plurality of rectifiers (22), each comprising a capacitor (24) connected in parallel with a diode (23), characterized in that a parallel connector of rectifier (22) and capacitor (24) is formed as an integrated unit of a semiconductor chip diode (23) and a capacitor (24) arranged in parallel with each other between and soldered to an arm-shaped external connection terminal (25) and a heat sink (26), respectively, and being insulated and sealed into a protecting sealing (28) of synthetic resin.

2. The rectifying apparatus according to claim 1, characterized in that the rectifier (22) is provided with a ring-shaped capacitor (24) mounted on one end of the arm-shaped external connection terminal (25) and surrounding the semiconductor chip diode (23), in that the heat sink (26) has a bottom provided with a projection at the center thereof, wherein the semiconductor chip diode (23) is connected at one end thereof to the projection of the heat sink (26), in that the capacitor (24) is connected at one end thereof to the periphery of the bottom of the heat sink (26), and in that the semiconductor chip diode (23) and the capacitor (24) are connected at the other ends thereof to the arm-shaped external connection terminal (25), wherein the connections are made by solder material (27) (Fig. 8—11).

3. The rectifying apparatus according to claim 1, characterized in that the capacitor (24) of the rectifier (22) is formed in a box shape, in that the heat sink (26) is formed as a planar component, in that the arm-shaped external connection terminal (25) is formed with a bent end (25a) at the center thereof and bent out towards the heat sink (26), wherein the semiconductor chip diode (23) is mounted towards the bent end (25a) of the arm-shaped external connection terminal (25), while the capacitor (24) is provided at the not-bent end (25b) of the arm-shaped external connection terminal (25), and in that the semiconductor chip diode (23) and the capacitor (24) are connected at the other ends thereof to the heat sink (26),

wherein the connections are made by solder material (27) (Fig. 12—15).

**Patentansprüche**

1. Gleichrichterschaltung für einen Kraftfahrzeug-Wechselstromgenerator, mit mindestens einer Gleichrichtereinrichtung (20, 21) zum Umwandeln eines Wechselstrom-Ausgangssignals (3) des Wechselstromgenerators (1) in einen Gleichstrom, wobei die Gleichrichtereinrichtung (20, 21) eine Vielzahl von Gleichrichtern (22) aufweist, die jeweils einen parallel zu einer Diode (23) geschalteten Kondensator (24) aufweisen, dadurch gekennzeichnet, daß eine Parallelschaltung aus Gleichrichter (22) und Kondensator (24) als integrierte Einheit einer Halbleiterchipdiode (23) und eines Kondensators (24) ausgebildet ist, die parallel zu einander angeordnet und an einen armförmigen externen Verbindungsanschluß (25) und einen Kühlkörper (26) zwischen diesen angelötet sowie isoliert und in eine Schutzabdichtung (28) aus Kunstharz eingeschlossen sind.

2. Gleichrichterschaltung nach Anspruch 1, dadurch gekennzeichnet, daß der Gleichrichter (22) mit einem ringförmigen Kondensator (24) versehen ist, der an einem Ende des armförmigen externen Verbindungsanschlusses (25) angebracht ist und die Halbleiterchipdiode (23) umgibt, daß der Kühlkörper (26) einen Boden aufweist, der in seiner Mitte mit einem Vorsprung versehen ist, wobei die Halbleiterchipdiode (23) an ihrem einen Ende mit dem Vorsprung des Kühlkörpers (26) verbunden ist, daß der Kondensator (24) an seinem einen Ende mit dem Umfang des Bodens des Kühlkörpers (26) verbunden ist, und daß die Halbleiterchipdiode (23) und der Kondensator (24) an ihren anderen Enden mit dem armförmigen externen Verbindungsanschluß (25) verbunden sind, wobei die Verbindungen mit Lötmaterial (27) ausgebildet sind (Fig. 8 bis 11).

3. Gleichrichterschaltung nach Anspruch 1, dadurch gekennzeichnet, daß der Kondensator (24) des Gleichrichters (22) eine kastenförmige Gestalt hat, daß der Kühlkörper (26) als ebene Komponente ausgebildet ist, daß der armförmige externe Verbindungsanschluß (25) in seiner Mitte mit einem gebogenen Ende (25a) ausgebildet und zu dem Kühlkörper (26) nach außen gebogen ist, wobei die Halbleiterchipdiode (23) an dem gebogenen Ende (25a) des armförmigen externen Verbindungsanschlusses (25) angebracht ist, während der Kondensator (24) am nichtgebogenen Ende (25b) des armförmigen externen Verbindungsanschlusses (25) vorgesehen ist, und daß die Halbleiterchipdiode (23) und der Kondensator (24) an ihren anderen Enden mit dem Kühlkörper (26) verbunden sind, wobei die Verbindungen mit Lötmaterial (27) ausgebildet sind (Fig. 12 bis 15).

**Revendications**

1. Redresseur pour alternateur de véhicule automobile, comprenant au moins un dispositif de redressement (20, 21) pour convertir une sortie (3) en courant alternatif de l'alternateur (1) en un courant continu, le dispositif de redressement (20, 21) ayant un certain nombre de redresseurs (22), chacun comprenant un condensateur (24) relié en parallèle avec une diode (23), caractérisé en ce qu'un connecteur en parallèle du redresseur (22) et du condensateur (24) est formé en une unité intégrée d'une diode sur pastille de semiconducteur (23) et d'un condensateur (24) agencé en parallèle l'un avec l'autre entre et soudés à une borne de connexion externe en forme de bras (25) et un radiateur de chaleur (26) respectivement en étant isolés et scellés dans un scellement protecteur (28) en résine synthétique.

2. Redresseur selon la revendication 1, caractérisé en ce que le redresseur (22) est pourvu d'un condensateur (24) de forme annulaire qui est monté à une extrémité de la borne de connexion externe en forme de bras (25) et qui entoure la diode (23) sur la pastille de semiconducteur, en ce que le radiateur de chaleur (26) a un fond pourvu d'une protubérance en son centre, où la diode (23) sur la pastille de semiconducteur est connectée à une extrémité à la protubérance du radiateur de chaleur (26), en ce que le condensateur (24) est relié à une extrémité au pourtour du fond du radiateur de chaleur (26) et en ce que la diode (23) sur la pastille de semiconducteur et le condensateur (24) sont reliés à leurs autres extrémités à la borne de connexion externe en forme de bras (25) où les connexions sont faites par un matériau de soudure (27) (Figures 8 à 11).

3. Redresseur selon la revendication 1, caractérisé en ce que le condensateur (24) du redresseur (22) a la forme d'une boîte, en ce que le radiateur de chaleur (26) a la forme d'un composant plan, en ce que la borne de connexion externe en forme de bras (25) présente une extrémité courbée (25a) en son centre et courbée vers l'extérieur vers le radiateur de chaleur (26), où la diode sur pastille de semiconducteur (23) est montée vers l'extrémité courbée (25a) de la borne de connexion externe en forme de bras (25) tandis que le condensateur (24) est prévu à l'extrémité non courbée (25b) de la borne de connexion externe en forme de bras (25), et en ce que la diode sur pastille de semiconducteur (23) et le condensateur (24) sont reliés à leurs autres extrémités au radiateur de chaleur (26), où les connexions sont faites par un matériau de soudure (27) (Figures 12—15).

# FIG. 1

# FIG. 2

# FIG. 3

# FIG. 4

# FIG. 5

# FIG. 6

# FIG. 7

# FIG. 8

# FIG. 9

# FIG. 10

# FIG. 11

4

# FIG. 12

22

25

28

26

C — C

# FIG. 13

22

D

25

26

28

D

# FIG. 14

22

25

27 23

28

27

26

25a

25b

25 24 27

# FIG. 15

22

25

25a

26

23

28

24